(19) Europäisches Patentamt
European Patent Office
Office européen des brevets

(11) **EP 2 455 768 A1**

(12) **EUROPEAN PATENT APPLICATION**
published in accordance with Art. 153(4) EPC

(43) Date of publication:
**23.05.2012 Bulletin 2012/21**

(51) Int Cl.:
*G01R 27/28* (2006.01)  *G01H 3/08* (2006.01)
*G01H 17/00* (2006.01)  *G10K 15/00* (2006.01)

(21) Application number: **10799765.2**

(22) Date of filing: **07.07.2010**

(86) International application number:
**PCT/JP2010/061567**

(87) International publication number:
**WO 2011/007706 (20.01.2011 Gazette 2011/03)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **17.07.2009 JP 2009168427**

(71) Applicant: **Etani Electronics Co., Ltd.**
**Tokyo 143-0011 (JP)**

(72) Inventors:
• **HINO, Shokichiro**
**Tokyo 143-0011 (JP)**

• **KOIDE, Hiroshi**
**Tokyo 143-0011 (JP)**
• **SHOJI, Akihiko**
**Tokyo 143-0011 (JP)**
• **TSUCHIYA, Koichi**
**Tokyo 143-0011 (JP)**
• **ENDO, Tomohiko**
**Tokyo 143-0011 (JP)**
• **XIE, Qiusheng**
**Tokyo 143-0011 (JP)**

(74) Representative: **TBK**
**Bavariaring 4-6**
**80336 München (DE)**

(54) **IMPULSE RESPONSE MEASURING METHOD AND IMPULSE RESPONSE MEASURING DEVICE**

(57)   An impulse response measurement with high precision is made possible with a simple device or signal processing, even if sampling clocks on the transmitting side and the receiving side are asynchronous at the time of measuring an impulse response of a measured system. An impulse response measuring method includes an input signal generating step of generating an input signal of an arbitrary waveform to be input to a measured system by using a synchronization signal having a first sampling clock frequency, a signal converting step of performing conversion on a measured signal output from the measured system into a discrete value system by using a synchronization signal having a second sampling clock frequency, and an inverse filter correcting step of correcting at least a phase of an inverse filter which is an inverse function of a function showing a frequency characteristic of the input signal according to a frequency ratio of the first sampling clock frequency and the second sampling clock frequency. Then, the impulse response of the measured system is measured using the inverse filter after correction.

FIG.1

**EP 2 455 768 A1**

**Description**

Technical Field

The present invention relates to an impulse response measuring method and an impulse response measuring device for measuring the transfer characteristic of a measured system such as acoustic equipment, an acoustic space, or a transmission line for an electrical signal, and in particular, to an impulse response measuring method and an impulse response measuring device with which the transfer characteristic can be measured accurately even if the frequency of a synchronization signal differs between processing devices on the transmitting side and the receiving side.

Background Art

Conventionally, a technique of grasping various acoustic characteristics, such as the frequency characteristic of a measured system, with an impulse response signal which has been reproduced by an acoustic reproduction device for reproducing an acoustic signal, has been widely known. Several methods have been proposed to measure this impulse response signal with high precision.

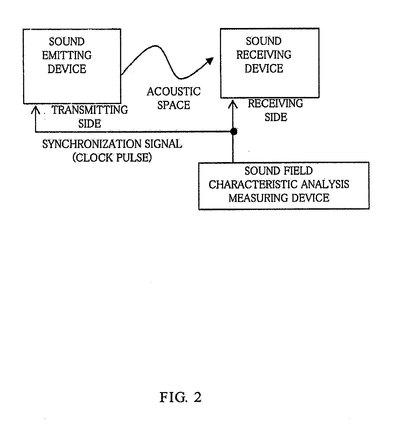

For example, in one conventional technique, the transfer characteristic of acoustic equipment or an acoustic space is measured using a plurality of identical signals (repetitive signals), the number of which is represented by I, and the signal-to-noise (S/N) ratio for a signal with random noise is improved (by 10logI dB) by performing synchronous averaging of the respective signals according to the repetition period of the signal. At this time, a common synchronization signal (clock pulse) is generally used at the transmitting side and the receiving side, as shown in Fig. 2, in order to perform synchronous addition accurately with respect to the repetition period of the repetitive signal. However, using a common clock pulse at the transmitting side and the receiving side requires a unification of measuring devices at the transmitting side and the receiving side or a transmission path for sharing a common clock pulse at the transmitting side and the receiving side.

For example, when an acoustic measurement for a large space such as an auditorium or a stadium is performed to measure the transfer characteristic of a particular space, a signal from a test signal generator (transmitting side) is supplied to a sound source amplifier, and sound is emitted into the space through a speaker and received at a sound receiving point for measurement. In order to grasp the difference between locations in a widely open space, sound is usually measured in a plurality of measurement points. At this time, in order for measuring devices to use identical clock pulses, a microphone for receiving sound is connected via a long cable for measurement, or the measuring device together with a microphone is moved and placed at a measurement point and is connected to the speaker side including the sound source amplifier through a cable.

Therefore, there has been a demand for an asynchronous measurement system with which a response measurement can be performed accurately without a common clock pulse at the transmitting side and the receiving side.

The inventors of the present invention have conceived a method (see Patent Literature 1 and Non-Patent Literature 1) in which a sampling data row is extracted for each of a plurality of consecutive signals converted from analog to digital at the receiving side of an asynchronous system, and a discrete Fourier transform (DFT) process is performed on each of the data rows for synchronous addition in the frequency domain instead of synchronous addition in the time domain.

There is also a proposed method (for example, see Patent Literature 2) which applies a time-stretched pulses (TSP) method to an asynchronous system. In order to perform synchronous addition in the time domain using sampling data rows of a plurality of identical signals which have been converted from analog to digital at the receiving side, a first signal data row and a subsequent signal data row are extracted at the receiving side, and a cross-correlation process between the extracted first signal data row as the reference and the subsequent signal data row is performed to obtain the peak of a cross-correlation value. Accordingly, the respective signal data rows are added with positions aligned in the synchronous addition.

In this method, the difference between the length (number of bits) of each data row obtained by sampling with a clock on the receiving side and the length (number of bits) of each data row on the transmitting side is obtained through the cross-correlation process described above. Then, when a convolution process with a signal after the synchronous addition and an inverse TSP signal is performed in the time domain in order to send out an impulse response waveform, the inverse TSP signal is re-sampled (to compensate for the number of generated signals), to obtain a corrected inverse TSP signal having a length of a data row corresponding to the length (number of clock pulses) of each data row obtained by sampling with the clock on the receiving side.

In addition, a method of randomizing or changing the interval between respective data rows in order to minimize the influence of external low-frequency noise has been proposed (for example, see Patent Literature 4 and Patent Literature 5).

In addition, a TSP method (for example, see Patent Literature 3 and Non-Patent Literature 2) is widely used for digital measurements of an impulse response. A TSP signal is a signal that changes from high frequency to low frequency or a signal that changes from low frequency to high frequency (signal that "sweeps" a frequency range), so that an impulse is extended along the time axis to increase energy. Thus, an impulse response measurement that results in a high S/N ratio can be performed. In a further attempt to improve the TSP method in recent years, a TSP filter which can further increase power in low frequency has been proposed (for example, see Patent Literature 6, Patent Literature 7, and Patent Literature 8).

Citation List

Patent Literature

Patent Literature 1: Japanese Patent No. 3718642
Patent Literature 2: Japanese Patent Application Laid-Open No. 2007-156393
Patent Literature 3: Japanese Patent No. 2725838
Patent Literature 4: Japanese Patent Application Laid-Open No. 2007-232492
Patent Literature 5: Japanese Patent Application Laid-Open No. Hei 06-265400
Patent Literature 6: Japanese Patent No. 2867769
Patent Literature 7: International Publication No.WO/2006/011356
Patent Literature 8: Japanese Patent No. 3766975 Non-Patent Literature

Non-Patent Literature 1: Hino, Tsuchiya, and Endo, "An Examination of the Synchronous Addition Method under an Asynchronous Measurement System," Preprints, presented at the AES 10th Regional Convention, Tokyo, June, 2001
Non-Patent Literature 2: Juro Ohga, Yoshio Yamasaki, and Yutaka Kaneda, "Acoustic Systems and Digital Processing," The Institute of Electronics, Information and Communication Engineers, pp. 158-159, 1995

Summary Of Invention

Technical Problem

In a measurement system or device using, for example, a CD player, the CD player detects TSP information recorded on a disc, performs analog conversion with a DA converter, and outputs sound through an amplifier and speaker within a measured room. Then, a computer on the receiving side captures the sound output from the speaker through a microphone, performs digital conversion with anAD converter, and performs signal processing for an impulse response measurement.

However, when the frequencies (or phases) differ between a sampling clock which is a synchronization signal of the DA converter on the CD player side (transmitting side) and a sampling clock of the AD converter of the computer (receiving side), i.e., when the sampling clocks on the transmitting side and the receiving side are asynchronous, there is a difference in sampling number (number of samples) represented in the same waveform and an error in measured signals. Thus, an accurate impulse response cannot be obtained.

Also, in the conventional technique described above (for example, technique described in Patent Literature 2), it is not easy to generate a data row of a corrected inverse TSP signal through re-sampling of the inverse TSP signal corresponding to a data row of the TSP signal at the time of transmission. It requires a complicated process such as, for example, storing a data row of the inverse TSP signal with high time-axis resolution in a large-capacity waveform memory and sequentially extracting the necessary data row of the inverse TSP signal according to the frequency ratio of synchronization signals (frequency ratio of sampling clock pulses) on the transmitting side and the receiving side to generate a data row of the corrected inverse TSP signal.

The present invention has been achieved in order to solve such problems, and it is an object of the present invention to provide an impulse response measuring method and an impulse response measuring device with which an impulse response measurement can be performed with high precision with a simple device or signal processing, even if sampling clocks on the transmitting side and the receiving side are asynchronous at the time of measuring an impulse response of a measured system.

Solution To Problem

The present invention provides an impulse response measuring method including: an input signal generating step of generating an input signal of an arbitrary waveform to be input to a measured system by using a synchronization signal having a first sampling clock frequency; a signal converting step of performing conversion on a measured signal output from the measured system into a discrete value system by using a synchronization signal having a second sampling clock frequency; and an inverse filter correcting step of correcting at least a phase of an inverse filter which is an inverse function of a function representing a frequency characteristic of the input signal according to a frequency ratio of the first sampling clock frequency and the second sampling clock frequency, wherein the inverse filter after correction is used to measure an impulse response of the measured system.

Also, the present invention provides an impulse response measuring device including: input signal generating means for generating an input signal of an arbitrary waveform to be input to a measured system by using a synchronization signal having a first sampling clock frequency; signal converting means for performing conversion on a measured signal output from the measured system into a discrete value system using a synchronization signal having a second sampling clock frequency; and inverse filter correction means for correcting at least a phase of an inverse filter to a generation filter of the input signal according to a frequency ratio of the first sampling clock frequency and the second sampling clock frequency, wherein the inverse filter after correction is used to measure an impulse response of the measured system. Advantageous Effects Of Invention

With the impulse response measuring method and the impulse response measuring device according to the present invention, an impulse response measurement can be performed with high precision with a simple device or signal processing, even if sampling clocks on the transmitting side and the receiving side are asynchronous at the time of measuring an impulse response of a measured system.

Also, when a signal from a test signal generator is supplied to a sound source amplifier and sound is emitted into a space through a speaker and received at a sound receiving point by a measuring device for measurement in an acoustic measurement for a large space such as an auditorium or a stadium, a correct impulse response measurement can be performed without using identical synchronization signals (clock pulses) deliberately in the test signal generator and the measuring device. Therefore, it is not required that a microphone for receiving sound is connected via a long cable for measurement, or the measuring device together with a microphone is moved and placed at a measurement point and is connected to the speaker side including the sound source amplifier through a cable.

In addition, the impulse response characteristic between existing acoustic equipment mounted on a car and a hearing position (driving position) of a person can be measured with measuring equipment not connected with the acoustic equipment through a cable. For example, it is possible to measure the impulse response characteristic of sound easily and with high precision with measuring equipment by recording repetitive TSP data for synchronous averaging on a CD and playing the CD with a CD player, which is acoustic equipment.

Brief Description Of Drawings

Fig. 1 is a block diagram showing one example of a process flow of an impulse response measurement using a TSP method in an asynchronous system.

Fig. 2 is a block diagram showing one example of a conventional synchronous system.

Fig. 3 is a graph showing one example of a change in the number of samples with respect to a receive signal according to the difference in sampling clock frequency on the transmitting side and the receiving side.

Fig. 4 is a view schematically showing the relationship regarding a scale factor $\alpha$ which is the frequency ratio of synchronization signals on the transmitting side and the receiving side in a continuous system and a discrete system.

Fig. 5 is a view schematically showing a circular shift process.

Fig. 6 is a view showing the phase-frequency characteristic of a TSP filter H(k) on the transmitting side and a TSP filter H(1) on the receiving side.

Fig. 7 (a) is a view schematically showing a data sequence when a plurality of data rows to be synchronously added are consecutive. Fig. 7 (b) is a view schematically showing a data sequence when a plurality of data rows to be synchronously added are at unequal intervals.

Fig. 8 is a view showing a specific example of the asynchronous system.

Fig. 9 (a) is a graph showing one example of an impulse waveform when a TSP inverse filter $H^{-1}$ (1) has not been corrected. Fig. 9 (b) is a graph showing one example of an impulse waveform when the TSP inverse filter $H^{-1}(1)$ has been corrected.

Fig. 10 is a view showing one example of a TSP waveform of h (t) .

Description Of Embodiments

An impulse response measuring method and an impulse response measuring device according to the present embodiment will be described below in detail with reference to the drawings.

<1. Overall configuration>

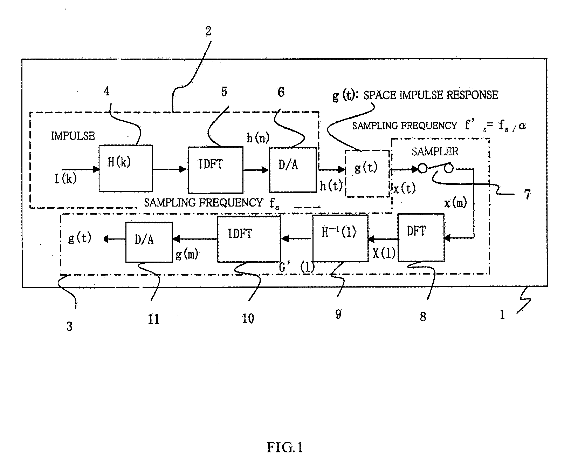

First, referring to Fig. 1, a process flow of an impulse response measurement using a TSP method in an asynchronous system will be described. Note that a high-precision detection method for the period of a plurality of identical signals (repetitive signals) in an asynchronous system and synchronous vector averaging which is synchronous averaging in the frequency domain will be described later.

As shown in the drawing, an asynchronous system 1 includes a transmitting side unit 2 and a receiving side unit 3 which operate at sampling clock frequencies (fs and f's) different from each other.

<1-1. Transmitting side unit>

In the transmitting side unit 2, an impulse input I (k) in the frequency domain is input to a TSP filter 4 having a transfer function of H(k) to obtain H(k)I(k) as an output of the TSP filter 4. Next, by performing an inverse discrete Fourier transform (IDFT) on H(k)I(k) which is the output of the TSP filter 4, a TSP signal h(n) which is a sample row in sync with the sampling clock frequency fs for data in the transmitting side unit 2 is obtained. Next, by causing the TSP signal h (n) to pass through a DA converter 6, a TSP signal h (t) is obtained. Then, by inputting the TSP signal h (t) to an object of measurement (measured system) including a space or the like having an impulse response characteristic g(t), an output of a measured signal x(t) = h (t) *g (t) (where * is a symbol for convolution) is obtained.

<1-2. Receiving side unit>

In the receiving side unit 3, the measured signal x(t) (which equals h(t)*g(t)) obtained from the measured system is sampled by a sampler (or AD converter) 7 at the sampling clock frequency f's, which equals $fs/\alpha$ (where $\alpha$ represents the frequency ratio), for data in the receiving side unit 3 to obtain an output signal x(m) which is a sample row in sync with the sampling clock frequency f's of the receiving side unit 3. Next, by performing DFT on the output signal x(m) in a DFT process unit 8, X(l) is obtained. By performing a multiplication $H^{-1}(1)X(1)$ of this X(1) and the transfer characteristic of a TSP inverse filter $H^{-1}(1)$ 9, G'(1) is obtained. Next, by performing IDFT on this G' (1) in an IDFT process unit 10, g (m) which is a sample row is obtained. By causing this g(m) to pass through a DA converter 11, g(t) is obtained as an impulse response waveform. Note that the DA converters 6 and 11 have a function of converting an input signal from digital to analog, creating a pulse row at an analog gate or the like, and performing interpolation with an analog lowpass filter.

In this manner, a DFT process, synchronous vector averaging in the frequency domain, and then multiplication by the transfer characteristic of the TSP inverse filter $H^{-1}$ (1) which is an inverse function of the TSP filter are performed in the receiving side unit 3 for x(m), an impulse response output of each of a plurality of the TSP signals. By taking into consideration the influence of the displacement of the sampling frequency with respect to this inverse function, the impulse response measurement can be performed with higher precision. The synchronous vector averaging in the frequency domain and a correction principle of a TSP inverse filter $H^{-1}(k)$ will be described below in detail.

<2. Synchronous vector averaging in the frequency domain>

First, the synchronous vector averaging in the frequency domain will be described in detail.

(Step 1) A data row of all signals subject to synchronous averaging which are output from the AD converter 7 of the receiving side unit 3 in sync with the sampling clock frequency f's of the receiving side unit 3 is read out as x(m). At this time, a plurality of respective signal data rows are extracted as consecutive sampling data rows, with synchronization data provided before the data rows subject to the synchronous averaging as the reference, based on a data format determined by the transmitting side unit 2.

(Step 2) The cross-correlation between a first signal data row and a subsequent signal data row is obtained, and a position error (phase difference) or synchronous position is estimated from a sampling clock number of the respective signal data rows and the phase between sampling clocks on the time axis where a correlation value comes to a peak. Such a position measurement of the respective data rows using cross-correlation is suitable for impulse response measurement using a TSP method in which the length of a data row can be increased on the receiving side (the receiving side unit 3), and increasing the length of a data row reduces the influence of noise on a cross-correlation value. This is because there is no correlation between signal and noise and between noise on one data row and noise on another.

(Step 3) Making use of the symmetry in the appearance of the correlation, interpolation using a quadratic function is performed in order to obtain an accurate position of a peak point of the cross-correlation value. Accordingly, phase information on the synchronous position can be obtained accurately.

(Step 4) In the DFT process unit 8, DFT is performed on the respective extracted data rows. When the sampling clock frequency of the receiving side unit 3 differs from the sampling clock frequency of the transmitting side unit 2, the phase of the position of each extracted data row varies. Therefore, DFT data obtained earlier is corrected by the amount of phase displacement for each frequency in the frequency domain which corresponds to the position error (time displacement), and complex vector averaging of the corrected DFT data is performed for each frequency. This is synchronous vector averaging.

The position error (time displacement) corresponds to the angle of the phase in the frequency domain. The mathematical relationship between a time displacement $\tau$ and a phase $\theta$ in the frequency domain is shown. Let $\omega$ denote the angular frequency in the frequency domain and $\theta(\omega)$ the amount of phase rotation at each angular frequency, and the following expression holds.

<Expression 1>

$$\theta(\omega) = -\omega\tau, \quad \omega = 2\pi f, \quad \tau = [C_N + \{C_\varphi/(2\pi)\}]/f's \quad (1)$$

Note that f's represents the sampling clock frequency, $C_N$ represents the sampling clock number existing within $\tau$ which is a position error time, and $C_\Phi$ represents the residual phase when the phase within $\tau$ is not measured with $2\pi C_N$. Since this value can have a resolution expressed with a numerical value, precision can be ensured without increasing data amount. This feature enables X(l) to be obtained as a result of DFT (transfer function) through which a vector addition and averaging process is performed for each frequency for the entire signal data row, after the amount of phase rotation has been adjusted for each frequency of signal data on which DFT has been performed according to the amount of time displacement of each extracted signal data row.

(Step 5) The result of synchronous addition is multiplied by the TSP inverse filter $H^{-1}(l)$ 9. IDFT is performed on the result in the IDFT process unit 10 to obtain g (m) as an impulse response waveform.

<3. Correction principle of the TSP inverse filter $H^{-1}(k)$>

Next, the correction principle of the TSP inverse filter $H^{-1}(k)$ will be described in detail.

Since x(m) which is a sample row of a response waveform of the receiving side unit 3 is sampled at a frequency different from the sampling frequency of the transmitting side unit 2, the TSP inverse filter $H^{-1}(1)$ needs to be generated according to the sampling frequency of the receiving side unit 3 in order to obtain a pulse row of impulse response through multiplication of X(l), which has been converted through DFT, by the TSP inverse filter $H^{-1}(l)$, and an IDFT on the result.

Let $\alpha$ (which equals fs/f's) denote the ratio of the sampling clock frequency fs of the transmitting side unit 2 and the sampling clock frequency f's of the receiving side unit 3.

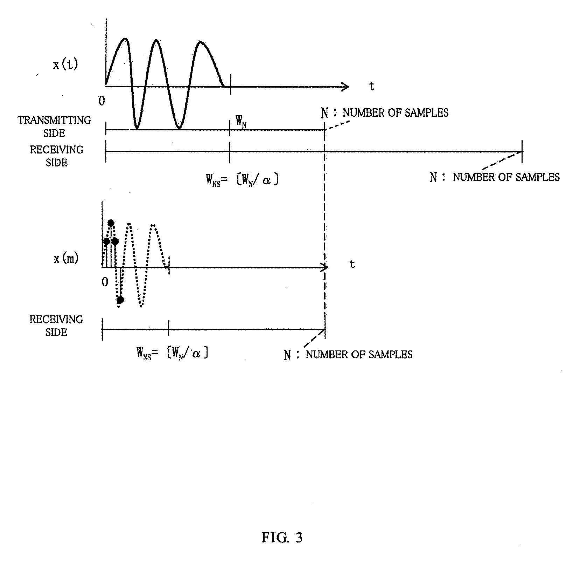

As shown in Fig. 3, when $\alpha > 1$ and the receiving side unit 3 tries to perform processing for a total number of N samples which is the same as in the transmitting side unit 2, the total number of samples in a detected signal width is reduced from $W_N$ in the transmitting side unit 2 to $W_{NS}$ (which equals $[W_N/\alpha]$) in the receiving side unit 3 (herein, [A] shows that A has been rounded to an integer). That is, it appears as if the waveform has shrunk in the time axis direction in a measurement based on the receiving side unit 3.

When X(l) is obtained by performing DFT on x(m) which is the sample row of a response waveform and multiplied by $H^{-1}(l)$ which is an inverse function of the TSP filter H(k) 4, it is necessary to use the TSP inverse filter $H^{-1}(1)$ 9 obtained by correcting the TSP filter H(k) 4 by the amount of change in the sampling frequency. In other words, it appears as if the detected waveform has shrunk, since the receiving side unit 3 performs processing based on the sampling clock frequency f's of the receiving side unit 3. Thus, assuming that absolute time does not change on the detecting side, the waveform is treated to have stretched or shrunk due to a change in sampling frequency.

In order to see the relationship to the frequency domain at this time, regard x(m) which is a sample row obtained by the receiving side unit 3 as x($\alpha$t) which is continuous, and consider the following formula (see E. Oran Brigham, "The Fast Fourier Transform," Prentice-Hall Inc., Chapter 3 (1974)) numbered (2) which shows the relationship regarding the scale factor $\alpha$ of time in a Fourier transform X(f) of x(t). The scale factor $\alpha$ is the ratio of the sampling clock frequency fs on the transmitting side and the sampling clock frequency f's on the receiving side described earlier.

<Expression 2>

$$x(\alpha t) \iff (1/|\alpha|) X(f/\alpha) \qquad (2)$$

Qualitatively, the appearance of the waveform shrinks along the time axis in the time domain but stretches on the frequency axis with reduced amplitude in the frequency domain, when $\alpha > 1$.

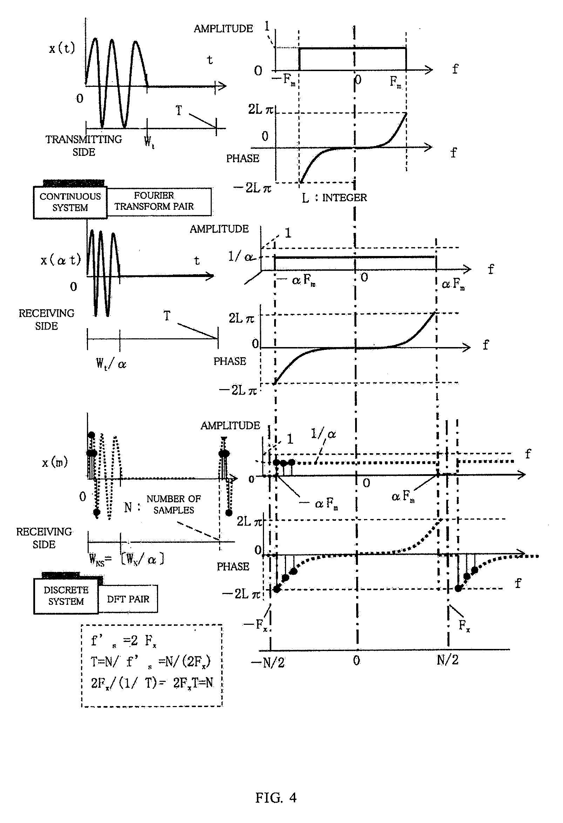

Fig. 4 is a view schematically showing the relationship regarding the scale factor $\alpha$ of time in a continuous system and a discrete system. The upper section and the middle section show the relationship regarding the expression (2) for the continuous system and the lower section shows the relationship regarding DFT for the discrete system.

For the continuous system, the amplitude-frequency characteristic and the phase-frequency characteristic of the signal $x(t)$ having a time length of Wt in a measurement time T and a frequency band of -Fm to +Fm are shown in the upper section, and the amplitude-frequency characteristic and the phase-frequency characteristic of a signal $x(\alpha t)$ when the scale factor $\alpha > 1$ are shown in the middle section. In the latter case of the signal $x(\alpha t)$ when the scale factor $\alpha > 1$, the waveform has a time length of Wt/$\alpha$ in the measurement time T, the frequency band is -$\alpha$Fm to +$\alpha$Fm, and the amplitude in the amplitude-frequency characteristic is 1/$\alpha$.

When DFT is performed on the signal $x(\alpha t)$ of a continuous system with the scale factor $\alpha$, the setting conditions are T for the repetition period of $x(\alpha t)$ of the signal and Fx > $\alpha$maxFm ($\alpha$max being the maximum value when $\alpha > 0$) for the bandwidth -Fx to +Fx in the frequency domain. The resulting DFT is a periodic function with a base frequency band of -FX to +Fx and a period of 2Fx in the frequency domain.

At this time, N which is the total number of samples on the time axis is set as N = $2^i$ (where i is an integer) in consideration of a fast Fourier transform (FFT) calculation. While the sampling frequency f's is sufficient at 2Fx or greater on the time axis, the setting herein is f's = 2Fx. The period T in time is set as T = N/f's. In the frequency domain at this time, a line spectrumappears at every 1/T as the frequency characteristic of the signal, and the characteristic in band -$\alpha$Fm to +$\alpha$Fm is repeated at a period of 2Fx on the frequency axis. Since 2Fx/(1/T) = N, the periodic function has a base frequency band of -N/2 to +N/2 - 1 and a period of N in the discrete frequency domain. Since a discrete signal row is assumed to repeat at the period T, the line spectrum appears at every 1/T in the frequency domain after DFT.

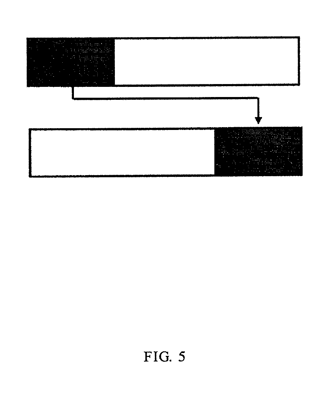

Up to this point, handling of discrete time in the presence of the scale factor $\alpha$ has been described. Note that Fig. 4 is a schematic view showing a response waveform $x(t)$ in a greatly simplified manner than an actual response waveform of a TSP signal. Also, since $h(n)$, which is a signal row resulting from IDFT in an IDFT process unit 5 on the output H(k)I(k) from the TSP filter H(k) 4, does not automatically appear in the beginning portion, it is assumed that a circular shift shown in Fig. 5 has been performed. That is, although the first signal row is shifted to the back, the result does not change since DFT assumes periodicity.

Next, a corrected TSP inverse filter $H^{-1}(1)$ when $x(m)$, which is a sample row of a response waveform of the receiving side unit 3, is sampled at a different frequency from the sampling clock frequency of the transmitting side unit 2 is derived.

An expression below has been proposed for H(k) of the TSP filter (transfer function) or discrete Fourier transform (DFT) (for example, see Patent Literature 3).

<Expression 3>

$$H(k) = \exp(j\beta k^2) \text{ where } 0 \leq k \leq M/2 \text{ (M is an integer)}$$

$$H*(M - k) = \exp\{-j\beta(M - k)^2\} \text{ where } (M/2) + 1 < k < M$$

$$\beta(M/2)^2 = 2L\pi \iff \beta = 8L\pi/M^2 \text{ (L is an integer)} \qquad (3)$$

In consideration of DFT with N points satisfying the condition N $\geq$ $\alpha$maxM in this expression, an expression 4 below is obtained from the expression 3. As shown in Fig. 4, there is a cyclic characteristic at a period of N.

<Expression 4>

$$H(k) = \exp(j\beta k^2) \text{ where } 0 \le k \le M/2 - 1$$

$$H*(k) = \exp(-j\beta k^2) \text{ where } (M/2) \le k < 0$$

$$H(k) = 0 \text{ where } -N/2 \le k \le -(M/2 + 1) \text{ and } (M/2) \le k \le N/2 - 1$$

$$\beta = 8L\pi/M^2 \text{ (L is an integer)} \tag{4}$$

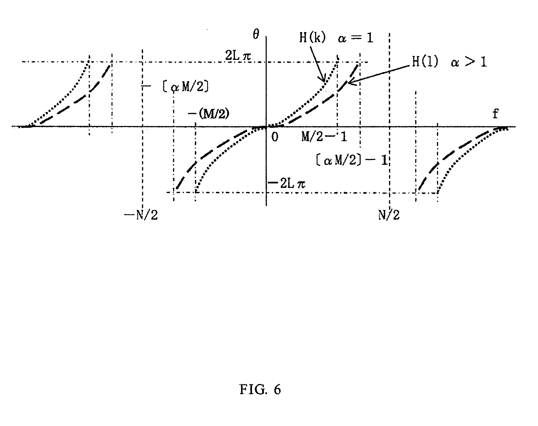

Regarding that the time axis of the detected waveform becomes $\alpha$ times the original based on the expression $x(\alpha t) \Leftrightarrow (1/|\alpha|)X(f/\alpha)$ of a Fourier transform pair shown above,
the frequency axis as a result of the Fourier transform becomes $1/\alpha$ times the original. Based on the use of the scale factor $\alpha$ in the DFT which has been discussed using Fig. 4, the characteristic of the phase $\theta$ of the TSP filter $H(k)$ of the transmitting side unit 2 and the TSP filter $H(l)$ of the receiving side unit 3 is as shown in Fig. 6. Note that the drawing shows a case where $\alpha > 1$.
By substituting $l/\alpha$ for k in the expression 4 and regarding the amplitude as $1/|\alpha|$, $H(l)$ for DFT is obtained.

<Expression 5>

$$H(l) = (1/|\alpha|)\exp\{j\beta(1/\alpha)^2\} = (1/|\alpha|)\exp\{j(\beta/\alpha^2)l^2\},$$
$$\text{where } 0 \le l \le [\alpha M/2] - 1$$

$$H*(l) = (1/|\alpha|)\exp\{-j(\beta/\alpha^2)l^2\}, \text{ where } -[\alpha M/2] \le l < 0$$

$$H(l) = 0, \text{ where } -N/2 \le l \le -[\alpha M/2] - 1 \text{ and } [\alpha M/2] \le l \le N/2 - 1$$

$$\beta = 8L\pi/M^2 \tag{5}$$

Note that $[\alpha M/2]$ shows a value calculated by $\alpha M/2$ and rounded to an integer. An example of rounding includes half-adjust.
When $l = -[\alpha M/2]$, substituting $\beta = 8L\pi/M^2$ into $H*(l)$ result in $H*(l) = (1/|\alpha|)\exp\{-j(2L\pi)\}$. Thus, in the phase characteristic shown in Fig. 6, the phase is $-2L\pi$ when $l = -[\alpha M/2]$.
The inverse function of $H(l)$ or inverse filter $H^{-1}(l)$ is as follows.

<Expression 6>

$$H^{-1}(l) = |\alpha|\exp\{-j(\beta/\alpha^2)l^2\}, \text{ where } 0 \le l \le [\alpha M/2] - 1$$

$$H*^{-1}(l) = |\alpha|\exp\{j(\beta/\alpha^2)l^2\}, \text{ where } -[\alpha M/2] \le l < 0$$

$$H^{-1}(l) = 0, \text{ where } -N/2 \le l \le -[\alpha M/2] - 1 \text{ and } [\alpha M/2] \le l \le N/2 - 1$$

$$\beta = 8L\pi/M^2$$

$$\alpha = fs/f's \text{ where fs denotes the sampling frequency on the transmitting side and f's denotes the sampling frequency on the receiving side} \tag{6}$$

Note that a time length $T_L$ of an impulse response in the measured system herein is less than or equal to the period T on the receiving side in Fig. 4.

In this manner, g(m) as a row of impulse responses can be obtained accurately by using the TSP inverse filter $H^{-1}$ (1) of the expression (6) even if the sampling frequency differs on the receiving side. Since the corrected TSP inverse filter $H^{-1}$(1) can be corrected at a resolution expressed with a numerical value, precision can be ensured without increasing data amount.

<4. Configuration of a plurality of data rows>

Herein, a case where a plurality of data rows to be added synchronously are consecutive and a case where intervals between the respective data rows are not constant will be discussed. For the latter case in particular, proposals have been made to increase resistance against external low-frequency noise (see Patent Literature 4 and Patent Literature 5).

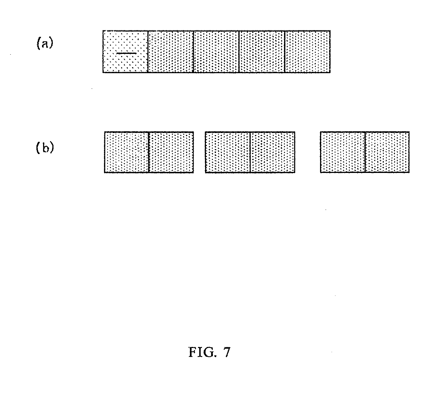

(1) A case where a plurality of data rows are consecutive (see Fig. 7a)

Since the period can be obtained from an autocorrelation of the entire data row or cross-correlation with an adjacent data row, the scale factor $\alpha$ at this time can be obtained through comparison with a period determined in advance at the transmitting side. A method of increasing precision through an interpolation process when obtaining the period with a cross-correlation process is similar to that for synchronous averaging described above. A first data row to be added synchronously is not treated as a data row for synchronous averaging when the waveform is not stable under the influence of a transient response of a circuit system or the like.

(2) A case where respective data rows are at unequal intervals (see Fig. 7B)

In this case, it is necessary to prevent a first end portion of data for synchronous averaging from being influenced by a transient response and a back end portion of the data from being lost in an extraction. Therefore, when the data row consists of N, two or greater, data rows is regarded as one data block, and the interval between the data blocks is changed. If transient response or data loss at the time of extraction is not an issue, the data block in the data block configuration may be one data row at N.

In the extraction of data, the respective signal data rows are extracted as consecutive sampling data rows in the format determined in advance, with synchronization data provided before the data rows subject to the synchronous addition as the reference. Then, the phase error of the respective extracted data rows is obtained through cross-correlation. Also, from a cross-correlation with the adjacent data row, the period of the data row is measured, and the period is compared with the period of the data row determined in advance on the transmitting side to obtain the scale factor $\alpha$.

In this manner, with the impulse response measuring method and the impulse response measuring device according to the present embodiment, synchronous addition can be performed with high precision even in an asynchronous system regardless of whether data rows to be added synchronously are consecutive or are at intervals which are not constant.

As described above, the impulse response measuring device according to the present embodiment includes: input signal generating means (for example, the DA converter 6 in the transmitting side unit 2) which generates an input signal of an arbitrary waveform to be input to a measured system by using a synchronization signal having a first sampling clock frequency (for example, fs); signal converting means (for example, the AD converter 7 and the DFT conversion unit 8 in the receiving side unit 3) which performs conversion on a measured signal output from the measured system into a discrete value system by using a synchronization signal having a second sampling clock frequency (for example, f's) ; and inverse filter correcting means which corrects at least a phase of an inverse filter (for example, the TSP inverse filter $H^{-1}$(k)) of a generation filter of the input signal according to a frequency ratio (for example, $\alpha$) of the first sampling clock frequency and the second sampling clock frequency, and is **characterized in that** the inverse filter after correction is used to measure an impulse response of the measured system. Note that the "inverse filter of a generation filter of the input signal" refers to a transfer function which is an inverse function of a function representing the discrete frequency characteristic of the input signal.

With the impulse response measuring device (or the impulse response measuring method) according to the present embodiment, an impulse response measurement can be performed with high precision with a simple device or signal processing, even if sampling clocks on the transmitting side and the receiving side are asynchronous at the time of measuring an impulse response of a measured system.

Also, when a signal from a test signal generator is supplied to a sound source amplifier and sound is emitted into a space through a speaker and received at a sound receiving point by a measuring device for measurement in an acoustic measurement for a large space such as an auditorium or a stadium, a correct impulse response measurement can be performed without using identical synchronization signals (clock pulses) deliberately in the test signal generator and the measuring device. Therefore, it is not required that a microphone for receiving sound is connected via a long cable for measurement, or the measuring device together with a microphone is moved and placed at a measurement point and is connected to the speaker side including the sound source amplifier through a cable.

Further, the impulse response characteristic between existing acoustic equipment mounted on a car and a hearing position (driving position) of a person can be measured with measuring equipment not connected with the acoustic equipment through a cable. For example, it is possible to measure the impulse response characteristic of sound easily and with high precision with measuring equipment by recording repetitive TSP data for synchronous averaging on a CD and playing the CD with a CD player, which is acoustic equipment.

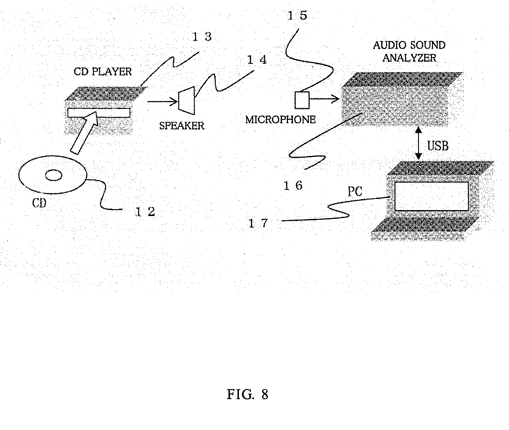

Further, it may be such that the input signal generating means uses, as a measurement signal source, a signal generator which repeatedly generates the input signals having the identical arbitrary waveforms at equal intervals or unequal intervals or a medium (for example, the CD 12 in Fig. 8) on which a signal identical to the input signal is recorded and a regenerator (for example, the CD player 13) which repeatedly reproduces the input signal, so as to input a repetitive signal generated from the measurement signal source to the measured system as the input signal. It may also be such that the signal converting means receives the measured signal at a receiving point, extracts the measured signal using waveform information in each period obtained from a waveform of the measured signal without using a common synchronization signal between the measurement signal source and the receiving point, obtains an amount of time displacement of the extracted waveform information in each period from an amount of time displacement for which a correlation value of cross-correlation between a period of reference and an another period is a true maximum value, corrects a phase based on phase displacement information for each frequency corresponding to the time displacement after converting a waveform in each period to information on amplitude and phase in a frequency domain for correction of the time displacement, and averages as a vector amount the information on amplitude and phase in each period in which the phase has been corrected earlier through conversion. It may also be such that the inverse filter correcting means obtains the frequency ratio based on a period of the repetitive signal or a signal period of the measured signal obtained through autocorrelation of the measured signal or cross-correlation between adjacent signals among repeated signals, corrects a phase of the inverse filter in a frequency domain of the repetitive signal of the measurement signal source according to the frequency ratio, calculates a product of a result of averaging in the signal converting step and the inverse filter after correction in the inverse filter correcting step, and converts a result of this calculation to time domain for measurement of the impulse response.

With this configuration, a noise reduction method using simple and high-precision synchronous averaging can be used even if the sampling clocks on the transmitting side and the receiving side are asynchronous. Thus, in an impulse response measurement, the precision of the impulse response measurement can further be improved in addition to providing agility to an operation on site and providing convenience and simplicity to the measuring method or the measuring device.

Also, after converting each period to the information on amplitude and phase in the frequency domain through discrete Fourier transform (DFT) for correction of the time displacement, the signal converting means may correct the phase based on the phase displacement information for each frequency corresponding to the time displacement and average the amounts of complex vectors in the respective frequencies acquiring a sum of the waveforms in the respective periods.

Also, the scale factor $\alpha$ used in the inverse filter correcting means may be obtained through interpolation for deriving a maximum value of a correlation value from the autocorrelation or the cross-correlation.

[Example 1]

As an example of the impulse response measuring method according to the present invention, a method of measuring the response characteristic between existing acoustic equipment mounted on a car and a hearing position (driving position) of a person without connecting the acoustic equipment and measuring equipment through a cable will be described.

As shown in Fig. 8, repetitive TSP data for synchronous averaging is recorded on a CD, the CD is played with a CD player which is the acoustic equipment, and reproduced sound is measured with measuring equipment (an audio sound analyzer 16, hereinafter referred to as ASA 16) in this impulse response measuring method.

This example will be described in more detail also with reference to Fig. 1 described above. On a CD 12, a plurality of identical TSP data rows of h (n) are recorded in succession. In this example, data recorded on the CD 12 is read out by a CD player 13, and the signal h(t) which has been read out is supplied to a speaker 14.

Sound output by the speaker 14 is converted to an electrical signal by a microphone 15 and then input to the ASA 16. Accordingly, the ASA 16 obtains x(t) as an output (waveform) of a sense amplifier. Note that the response waveform of x(t) obtained by the ASA 16 includes the characteristic of the space and the characteristic of the speaker 14. The ASA 16 transfers x(m) which is a plurality of consecutive data rows of the response waveform to a personal computer (PC) 17 via a USB interface or the like.

Based on a data format recorded on the CD 12, the PC 17 extracts a plurality of respective signal data rows as consecutive sampling data rows, with synchronization data provided before the data rows subject to the synchronous addition as the reference, and obtains the position error (time difference) between x(m) of the respective data rows through a cross-correlation process and the repeated signal period through autocorrelation to obtain the scale factor $\alpha$ which is a sampling frequency ratio in relation to the input end. Subsequently, the PC 17 obtains each X(l) by performing DFT in the DFT process unit 8 on x(m) of the respective data rows and obtains the amount of phase correction from data position information obtained earlier to correct the phase of each X(l) for each frequency. Subsequently, the PC 17 performs synchronous vector addition with respect to each of the plurality of phase-corrected X(l). Finally, the PC 17 obtains the function of the TSP inverse filter $H^{-1}$(l) 9 corrected with the scale factor $\alpha$, performs the multiplication G' (l) = $W^{-1}$(l)X(l) using X (l) which is the result of synchronous vector averaging, performs an inverse fast Fourier transform (IFFT) on the result in the IDFT process unit 10, generates g (m) as a row of impulse responses, and displays this result on a display unit.

Since a synchronization data row is provided before the data rows subject to synchronous addition as a data format on the transmitting side in this embodiment, a synchronization position can be determined through synchronization with the synchronization data row within data of a received signal on the receiving side. That is, the location of data can be known. However, data may be processed with the position where the data first appears as the reference, without providing the synchronization data.

Also, in order to extract the synchronization data row and all of the signal data rows subj ect to synchronous addition, which are obtained on the receiving side, the consecutive data rows are extracted using the fact that the data format on the transmitting side is known in advance in this example. However, the repetition period of data may be obtained through autocorrelation to extract the respective data rows, as long as identical repetitive data rows subject to synchronous averaging are consecutive.

Next, the validity and effect of the TSP inverse filter $H^{-1}$(l) according to the present embodiment are confirmed through simulation in a state without a measured object such as an acoustic space. For that purpose, it was tested to see how the impulse waveform changes depending on whether the TSP inverse filter is corrected or not when the waveform on the receiving side is displaced in the direction of time due to a change in sampling frequency of the transmitting side.

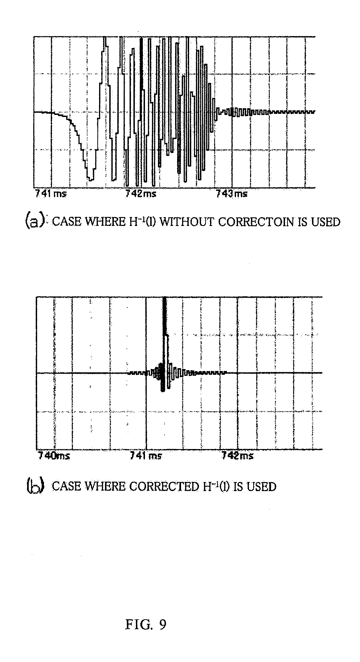

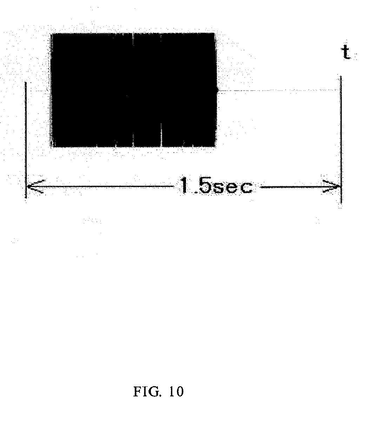

Note that the simulation is conducted under the following conditions. The synchronous addition is performed five times, the sampling frequency fs is 44.1 kHz, and constants used in the expression (4) and the expression (6) are 65536 for N, 8192 for L, 65536 × $\alpha$ for M, 0.999 (-0.1%) for $\alpha$, and 1.5 seconds for T. The simulation result is shown in Fig. 9. Also, the TSP waveform of h(t) at this time is shown in Fig. 10.

As shown in Fig. 9a, the waveform is far from an impulse waveform when the TSP inverse filter $H^{-1}$(l) is not corrected. However, as shown in Fig. 9b, an impulse waveform can be obtained with high precision even when the sampling frequencies on the transmitting side and the receiving side in an asynchronous system differ, if the TSP inverse filter $H^{-1}$(l) is corrected.

Note that the configuration of the impulse response measuring method and the impulse response measuring device according to the present invention is not limited to the configuration shown in the embodiment described above. It is obvious that various changes may be made without departing from the gist of the present invention.

Thus, although an example of synchronous vector averaging in the frequency domain in a process of impulse response measurement has been shown in the embodiment described above, an impulse response measurement may be performed without performing the synchronous vector averaging in the frequency domain when the impulse response measurement does not require very high precision, for example.

That is, the impulse response measuring method and the impulse response measuring device according to the present invention can use any configuration as long as it is configured such that an input signal of an arbitrary waveform to be input to a measured system is generated by using a synchronization signal having a first sampling clock frequency, conversion on a measured signal output from the measured system into a discrete value system is performed by using a synchronization signal having a second sampling clock frequency, at least a phase of an inverse filter for the input signal is corrected according to a frequency ratio of the first sampling clock frequency and the second sampling clock frequency, and an impulse response of the measured system is measured using the inverse filter after correction.

Industrial Applicability

The impulse response measuring method and the impulse response measuring device according to the present invention can be used for measuring the transfer characteristic of a measured system such as acoustic equipment, an acoustic space, or a transmission line for an electrical signal.

Reference Signs List

| | |
|---|---|
| 1 | asynchronous system |
| 2 | transmitting side unit |
| 3 | receiving side unit |
| 4 | TSP filter |
| 5 | IDFT process unit |
| 6, 11 | DA converter |
| 7 | sampler (or AD converter) |
| 8 | DFT process unit |
| 9 | TSP inverse filter $H^{-1}(I)$ |
| 10 | IDFT process unit |
| 12 | CD |
| 13 | CD player |
| 14 | speaker |
| 15 | microphone |
| 16 | audio sound analyzer (ASA) |
| 17 | PC |

**Claims**

1. An impulse response measuring method comprising:

an input signal generating step of generating an input signal of an arbitrary waveform to be input to a measured system by using a synchronization signal having a first sampling clock frequency;
a signal converting step of performing conversion on a measured signal output from the measured system into a discrete value system by using a synchronization signal having a second sampling clock frequency; and
an inverse filter correcting step of correcting at least a phase of an inverse filter which is an inverse function of a function representing a frequency characteristic of the input signal according to a frequency ratio of the first sampling clock frequency and the second sampling clock frequency, wherein
the inverse filter after correction is used to measure an impulse response of the measured system.

2. The impulse response measuring method according to claim 1, wherein
the input signal generating step uses, as a measurement signal source, a signal generator which repeatedly generates the input signals having the identical arbitrary waveforms at equal intervals or unequal intervals or a medium on which a signal identical to the input signal is recorded and a regenerator which repeatedly reproduces the input signal to input a repetitive signal generated from the measurement signal source to the measured system as the input signal;
the signal converting step receives the measured signal at a receiving point, extracts the measured signal using waveform information in each period obtained from a waveform of the measured signal without using a common synchronization signal between the measurement signal source and the receiving point, obtains an amount of time displacement of the extracted waveform information in each period from an amount of time displacement for which a correlation value of cross-correlation between a period of reference and an another period is a true maximum value, corrects a phase based on phase displacement information for each frequency corresponding to the time displacement after a waveform in each period has been converted to information on amplitude and phase in a frequency domain for correction of the time displacement, and averages as a vector amount the information on amplitude and phase for each frequency in each period in which the phase has been corrected earlier through conversion; and
the inverse filter correcting step obtains the frequency ratio based on a period of the repetitive signal or a signal period of the measured signal obtained through autocorrelation of the measured signal or cross-correlation between adjacent signals among repeated signals, corrects a phase of the inverse filter in a frequency domain according to the frequency ratio, calculates a product of a result of averaging in the signal converting step and the inverse filter after correction in the inverse filter correcting step, and converts a result of this calculation to time domain for measurement of the impulse response.

3. The impulse response measuring method according to claim 2, wherein the signal converting step converts each period to the information on amplitude and phase in the frequency domain through discrete Fourier transform (DFT) for correction of the time displacement, then corrects the phase based on the phase displacement information for each frequency corresponding to the time displacement, and averages a complex vector amount at each frequency for acquiring a sum of the waveform information in each period.

4. The impulse response measuring method according to claim2 or 3, wherein the inverse filter correcting step obtains the maximum value of the correlation value from the autocorrelation or the cross-correlation through interpolation.

5. An impulse response measuring device comprising:

input signal generating means for generating an input signal of an arbitrary waveform to be input to a measured system by using a synchronization signal having a first sampling clock frequency;
signal converting means for performing conversion on a measured signal output from the measured system into a discrete value system using a synchronization signal having a second sampling clock frequency; and
inverse filter correction means for correcting at least a phase of an inverse filter to a generation filter of the input signal according to a frequency ratio of the first sampling clock frequency and the second sampling clock frequency, wherein
the inverse filter after correction is used to measure an impulse response of the measured system.

6. The impulse response measuring device according to claim 5, wherein
the input signal generating means uses, as a measurement signal source, a signal generator which repeatedly generates the input signals having the identical arbitrary waveforms at an equal interval or unequal interval, or a medium on which a signal identical to the input signal is recorded and a regenerator which repeatedly reproduces the input signal to input a repetitive signal generated from the measurement signal source to the measured system as the input signal;
the signal converting means receives the measured signal at a receiving point, extracts the measured signal using waveform information in each period obtained from a waveform of the measured signal without using a common synchronization signal between the measurement signal source and the receiving point, obtains an amount of time displacement of each extracted period from an amount of time displacement for which a correlation value of cross-correlation between a period of reference and an another period is a true maximum value, corrects a phase based on phase displacement information for each frequency corresponding to the time displacement after converting a waveform in each period to information on amplitude and phase in a frequency domain for correction of the time displacement, and averages as a vector amount the information on amplitude and phase for each frequency in each period in which the phase has been corrected earlier through conversion; and
the inverse filter correcting means obtains the frequency ratio based on a period of the repetitive signal or signal period of the measured signal obtained through autocorrelation of the measured signal or cross-correlation between adjacent signals among repeated signals, corrects a phase of the inverse filter in a frequency domain according to the frequency ratio, calculates a product of a result of averaging in the signal converting step and the inverse filter after correction in the inverse filter correcting step, and converts a result of this calculation to time domain for measurement of the impulse response.

7. The impulse response measuring device according to claim 6, wherein the signal converting means converts each period to the information on amplitude and phase in the frequency domain through discrete Fourier transform (DFT) for correction of the time displacement, then corrects the phase based on the phase displacement information for each frequency corresponding to the time displacement, and averages a complex vector amount at each frequency for acquiring a sum of the waveform information in each period.

8. The impulse response measuring device according to claim 6 or 7, wherein the inverse filter correcting means obtains the maximum value of the correlation value from the autocorrelation or the cross-correlation through interpolation.

g (t): SPACE IMPULSE RESPONSE

SAMPLING FREQUENCY $f'_s = f_s / \alpha$

FIG.1

SOUND
EMITTING
DEVICE

ACOUSTIC
SPACE

SOUND
RECEIVING
DEVICE

TRANSMITTING
SIDE

RECEIVING
SIDE

SYNCHRONIZATION SIGNAL
(CLOCK PULSE)

SOUND FIELD
CHARACTERISTIC ANALYSIS
MEASURING DEVICE

FIG. 2

FIG. 3

FIG. 4

FIG. 5

FIG. 6

(a)

(b)

FIG. 7

FIG. 8

(a) CASE WHERE H⁻¹(l) WITHOUT CORRECTOIN IS USED

(b) CASE WHERE CORRECTED H⁻¹(l) IS USED

FIG. 9

FIG. 10

## INTERNATIONAL SEARCH REPORT

| | International application No. |
|---|---|
| | PCT/JP2010/061567 |

A. CLASSIFICATION OF SUBJECT MATTER
*G01R27/28*(2006.01)i, *G01H3/08*(2006.01)i, *G01H17/00*(2006.01)i, *G10K15/00*
(2006.01)i

According to International Patent Classification (IPC) or to both national classification and IPC

B. FIELDS SEARCHED

Minimum documentation searched (classification system followed by classification symbols)
G01R27/28, G01H3/08, G01H17/00, G10K15/00

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-156393 A (Pioneer Corp.),<br>21 June 2007 (21.06.2007),<br>entire text; all drawings<br>(Family: none) | 1-8 |
| A | JP 3718642 B2 (Etani Electronics Co., Ltd.),<br>24 November 2005 (24.11.2005),<br>entire text; all drawings<br>(Family: none) | 1-8 |
| A | JP 2004-193782 A (Etani Electronics Co., Ltd.),<br>08 July 2004 (08.07.2004),<br>entire text; all drawings<br>& US 2006/0140414 A1    & EP 1578169 A1<br>& WO 2004/054319 A1 | 1-8 |

☐ Further documents are listed in the continuation of Box C.   ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 31 August, 2010 (31.08.10) | 07 September, 2010 (07.09.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3718642 B
- JP 2007156393 A
- JP 2725838 B
- JP 2007232492 A
- JP HEI06265400 B
- JP 2867769 B
- WO 2006011356 A
- JP 3766975 B

**Non-patent literature cited in the description**

- An Examination of the Synchronous Addition Method under an Asynchronous Measurement System. **Hino ; Tsuchiya ; Endo.** Preprints, presented at the AES 10th Regional Convention, Tokyo. June 2001
- **Juro Ohga ; Yoshio Yamasaki ; Yutaka Kaneda.** Acoustic Systems and Digital Processing. *The Institute of Electronics, Information and Communication Engineers,* 1995, 158-159
- **E. Oran Brigham.** The Fast Fourier Transform. Prentice-Hall Inc, 1974